(19) Europäisches Patentamt
European Patent Office
Office européen des brevets

(11) **EP 4 387 015 A1**

(12) **EUROPEAN PATENT APPLICATION**
published in accordance with Art. 153(4) EPC

(43) Date of publication:
**19.06.2024 Bulletin 2024/25**

(21) Application number: **22855710.4**

(22) Date of filing: **18.03.2022**

(51) International Patent Classification (IPC):
**H01S 5/02253** (2021.01)   **H01S 5/02255** (2021.01)
**H01S 5/14** (2006.01)   **G02B 3/00** (2006.01)

(52) Cooperative Patent Classification (CPC):
**G02B 3/00; H01S 5/02253; H01S 5/02255;
H01S 5/14**

(86) International application number:
**PCT/JP2022/012827**

(87) International publication number:
**WO 2023/017644 (16.02.2023 Gazette 2023/07)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **10.08.2021 JP 2021130655**

(71) Applicant: **Panasonic Intellectual Property
Management Co., Ltd.
Kadoma-shi, Osaka 571-0057 (JP)**

(72) Inventors:
• **IIYAMA, Tomoko
Osaka 571-0057 (JP)**
• **ICHIHASHI, Kouki
Osaka 571-0057 (JP)**

(74) Representative: **Eisenführ Speiser
Patentanwälte Rechtsanwälte PartGmbB
Postfach 10 60 78
28060 Bremen (DE)**

(54) **OPTICAL SYSTEM AND LASER DEVICE, COLLIMATOR LENS**

(57) An optical system (4) includes: a first collimator lens (41) disposed facing the light source array, configured to collimate each light beam in at least a vertical direction (Y), intersecting an arrangement direction (X) of light sources and an optical axis direction (Z) of each light beam, among the vertical direction and the arrangement direction; an optical element (42) disposed on an emission side of each light beam in the first collimator lens; and a second collimator lens (45) disposed on an emission side of each light beam in the optical element, configured to collimate each light beam at least in the arrangement direction. The first collimator lens (43) includes lens portions arranged in the arrangement direction, the lens portions corresponding to the light sources in the light source array. The lens portions are configured rotationally asymmetrically to have positive power in the vertical direction and have positive power in the arrangement direction.

Fig. 6A

**(Cont. next page)**

*Fig. 6B*

**Description**

TECHNICAL FIELD

The present disclosure relates to an optical system used in a laser processing device or the like, a laser device, and a collimator lens.

BACKGROUND ART:

Patent Document 1 discloses a wavelength-combining laser system in which individual light beams are superposed to form a combined beam. Patent Document 1 discloses that light beams from a plurality of diode bars are condensed on an optical fiber from a viewpoint of increasing light output. For the purpose of reducing the size of the laser system, an optical system for removing the placement of a light combining lens from the focal length in wavelength synthesis is separately included, or a beam rotor is rotated.

Patent Documents

Patent Document 1: US 2016/0048028

SUMMARY

The present disclosure provides an optical system, a laser device, and a collimator lens capable of facilitating simple configuration of an optical system for guiding a plurality of light beams from a light source array.

In an aspect of the present disclosure, an optical system is provided for guiding a plurality of light beams from a light source array in which a plurality of light sources are arranged. The optical system includes: a first collimator lens disposed facing the light source array, configured to collimate each light beam in at least a vertical direction among the vertical direction and an arrangement direction of the plurality of light sources, the vertical direction intersecting the arrangement direction and an optical axis direction of each light beam; an optical element disposed on an emission side of each light beam in the first collimator lens; and a second collimator lens disposed on an emission side of each light beam in the optical element, configured to collimate each light beam at least in the arrangement direction. The first collimator lens includes a plurality of lens portions arranged in the arrangement direction, the plurality of lens portions corresponding to the plurality of light sources in the light source array. The plurality of lens portions are configured rotationally asymmetrically to have positive power in the vertical direction and have positive power in the arrangement direction.

In an aspect of the present disclosure, a laser device includes: a light source array including a plurality of light sources arranged in the arrangement direction, configured to emit the plurality of light beams; and the optical system configured to guide the plurality of light beams from the light source array.

In an aspect of the present disclosure, a collimator lens is provided for collimating a plurality of light beams from a light source array in which a plurality of light sources are arranged. The collimator lens includes a plurality of first lens portions arranged in the arrangement direction, the plurality of lens portions corresponding to the plurality of light sources in the light source array. The plurality of first lens portions are provided rotationally asymmetrically to have positive power in a vertical direction and to have positive power in the arrangement direction, the vertical direction intersecting the arrangement direction and an optical axis direction of each of the light beams.

According to the present disclosure, it is possible to provide an optical system, a laser device, and a collimator lens capable of facilitating simple configuration of an optical system for guiding a plurality of light beams from a light source array.

BRIEF DESCRIPTION OF DRAWINGS

Fig. 1 is a diagram illustrating a configuration of a laser processing device according to a first embodiment of the present disclosure;
Fig. 2 is a diagram illustrating a configuration of an optical resonator in the laser processing device of the first embodiment;
Fig. 3 is a diagram illustrating a configuration of a beam-twister unit (BTU) in a collimator optical system of the first embodiment;
Fig. 4 is a diagram illustrating a configuration of a fast-axis collimator (FAC) in the BTU of the first embodiment;

Fig. 5 is a diagram illustrating a configuration of a beam twister (BT) in the BTU of the first embodiment;

Figs. 6A and 6B are diagrams for explaining a collimating function in a fast axis in the collimator optical system of the first embodiment;

Figs. 7A and 7B are diagrams for explaining a typical example of a collimator optical system;

Figs. 8A and 8B are diagrams for explaining a collimating function in a slow axis in the collimator optical system of the first embodiment;

Fig. 9 is a diagram illustrating a method of combining light beams in the optical resonator of the first embodiment;

Fig. 10 is a graph showing a spectrum of a resonance wavelength in the optical resonator;

Figs. 11A and 11B are diagrams for explaining a numerical simulation for a light spot in the collimator optical system of the first embodiment;

Fig. 12 is a table showing a numerical example in the collimator optical system of the first embodiment;

Figs. 13A and 13B are diagrams illustrating a configuration of a collimator optical system according to a second embodiment;

Fig. 14 is a perspective view illustrating a configuration of an FAC in the second embodiment;

Figs. 15A and 15B are diagrams for explaining a numerical simulation for a light spot in the collimator optical system of the second embodiment;

Fig. 16 is a table showing a numerical example in the collimator optical system of the second embodiment;

Fig. 17 is a perspective view illustrating a configuration of an FAC in a third embodiment;

Fig. 18 is a diagram for explaining a numerical simulation for a light spot in a collimator optical system of the third embodiment;

Fig. 19 is a table showing a numerical example in the collimator optical system of the third embodiment;

Fig. 20 is a perspective view illustrating a configuration of an FAC in a fourth embodiment;

Fig. 21 is a diagram for explaining a numerical simulation for a light spot in a collimator optical system of the fourth embodiment; and

Fig. 22 is a table showing a numerical example in the collimator optical system of the fourth embodiment.

DETAILED DESCRIPTION

Hereinafter, embodiments will be described in detail with reference to the drawings as needed. However, description more detailed than necessary may be omitted. For example, detailed description of already well-known matters and redundant description of substantially the same configuration may be omitted. This is to avoid unnecessary redundancy in the following description and to facilitate understanding by those skilled in the art.

In addition, the inventor(s) provide(s) the accompanying drawings and the following description in order to enable those skilled in the art to sufficiently understand the present disclosure, which is not intended to limit the claimed subject matter.

(First Embodiment)

In a first embodiment, a wavelength-combining optical resonator and a laser processing device including the same will be described as an example of a laser device.

1. Configuration

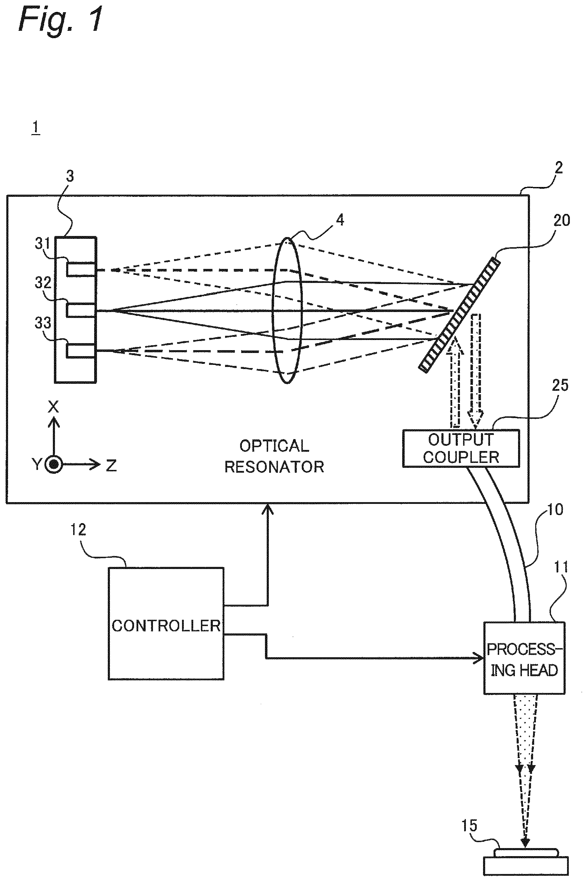

A configuration of a laser processing device and an optical resonator according to a first embodiment will be described with reference to Fig. 1. Fig. 1 is a diagram showing a configuration of a laser processing device 1 according to the present embodiment.

For example, as shown in Fig. 1, a laser processing device 1 includes an optical resonator 2, a transmission optical system 10, a processing head 11, and a controller 12. The laser processing device 1 is an example of a laser device that irradiates various processing objects 15 with laser light to perform various laser processing. Examples of the various laser processing include laser welding, laser cutting, and laser drilling.

The optical resonator 2 is an example of a laser device that generates laser light output from the laser processing device 1, for example. In the present embodiment, the optical resonator 2 is a wavelength-combining external resonator that resonates and combines a plurality of light beams at respective wavelengths. The wavelength-combining optical resonator 2 makes it easy to obtain favorable beam quality and to narrow the beam diameter.

As shown in Fig. 1, the optical resonator 2 according to the present embodiment includes a laser diode (LD) array 3 in which a plurality of laser elements 31 to 33 are arranged, an output coupler 25 that emits output light, and an optical system (4, 20) disposed between the LD array 3 and the output coupler 25. Hereinafter, a direction in which the laser elements 31 to 33 are arranged is referred to as an "X direction", a direction of an optical axis of a light beam emitted from each of the laser elements 31 to 33 by the LD array 3 is referred to as a "Z direction", and a direction orthogonal to the X and Z directions is referred to as a "Y direction". The generic term of the laser elements 31 to 33 may be "laser elements 30".

The LD array 3 in the optical resonator 2 is an example of a light source array including a plurality of laser elements 30. Fig. 1 illustrates three laser elements 31 to 33 included in the LD array 3. For example, the number of laser elements 30 included in the LD array 3 is several tens to several hundreds.

The optical system (4, 20) in the optical resonator 2 includes a diffractive element 20 and a collimator optical system 4 that collimates each light beam incident on the diffractive element 20, for example. The optical resonator 2 of the present embodiment causes each light beam of a specific wavelength band to resonate in an optical path that reciprocates between the LD array 3 and the output coupler 25 via the optical system described above.

In the optical system for use in such an optical resonator 2, the present embodiment provides an optical system that can simplify the placing configuration by reducing the number of components or by other means while ensuring the beam quality of the laser processing device 1. The configuration of the optical system and the like in the optical resonator 2 will be described later.

In the laser processing device 1, the transmission optical system 10 is an optical system that transmits the laser light from the optical resonator 2 to the processing head 11, and includes e.g. an optical fiber. For example, the processing head 11 is a device that is disposed facing the processing object 15 and irradiates the processing object 15 with the laser light transmitted from the optical resonator 2.

The controller 12 is a control device that controls the entire operation of the laser processing device 1. For example, the controller 12 includes a central processing unit (CPU) or a micro-processing unit (MPU) that achieves a predetermined function in cooperation with software. The controller 12 may include an internal memory that stores various programs and data, and various interfaces that enables a user to input oscillation conditions and the like through user operations. The controller 12 may include a hardware circuit, such as an application-specific integrated circuit (ASIC) or a field-programmable gate array (FPGA), that achieves various functions. The controller 12 may be configured integrally with a drive circuit of a light source.

1-1. Optical resonator

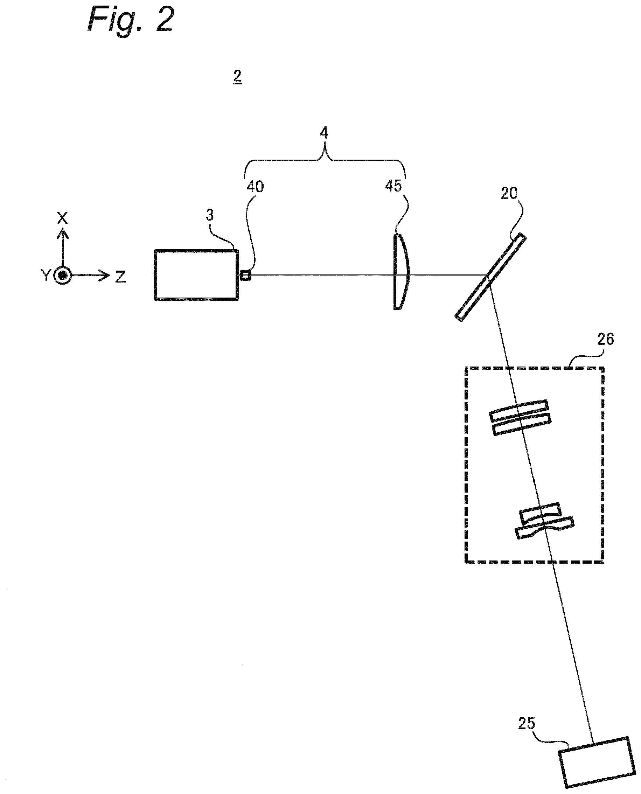

The configuration of the optical system and the like of the optical resonator 2 according to the present embodiment will be described with reference to Fig. 2.

Fig. 2 illustrates a configuration of an optical resonator 2 in the laser processing device 1 of the first embodiment. In the optical resonator 2 of the present embodiment, the collimator optical system 4 includes a beam-twister unit (BTU) 40 and a fast-axis collimator (FAC) 45 as shown in Fig. 2, for example (details will be described later). In the present configuration example, the optical resonator 2 may further include a telescope optical system 26 disposed between the diffractive element 20 and the output coupler 25.

In the optical resonator 2, the LD array 3 includes a direct diode laser, for example. A high reflectance coating with a reflectance of e.g. 99.9% or more is applied to the rear end surface (i.e., -Z side) of the LD array 3. For example, an antireflection coating with a transmittance of 99.9% or more is applied to the front (i.e., +Z side) end surface of the LD array 3. The plurality of laser elements 30 in the LD array 3 have a common spontaneous emission spectrum corresponding to material of an LD light emitting layer, for example. For example, the spectrum corresponds to a resonance wavelength band, and is e.g. a blue region with a wavelength of 400 nm to 450 nm.

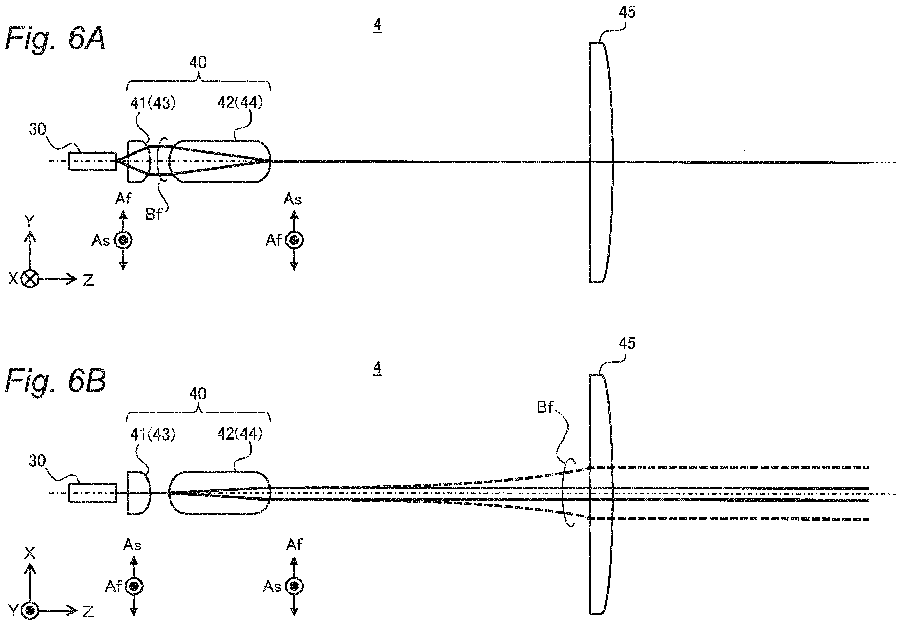

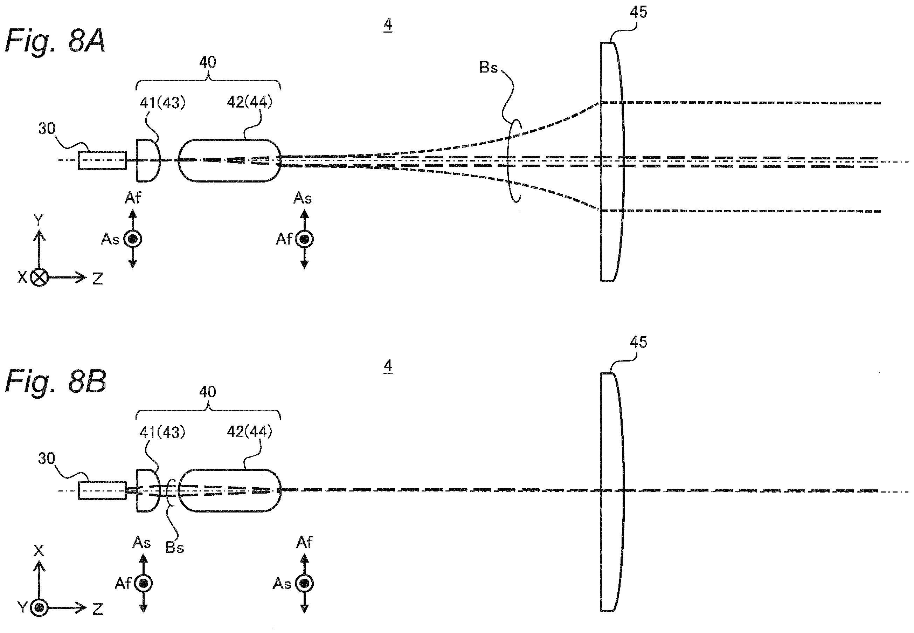

In the present embodiment, the LD array 3 emits light beams having a fast axis with a relatively larger divergence angle and a slow axis with a relatively smaller divergence angle from each laser element 30 (cf. Figs. 6 and 8). The fast axis of the light beam causes the beam diameter to expand more rapidly than the slow axis, making it easier to obtain fine beam quality. Each laser element 30 is an example of a light source constituting an emitter of the LD array 3, and emits a light beam to the +Z side.

For example, the diffractive element 20 is disposed at a position away from the FAC 45 of the collimator optical system 4 on the +Z side. For example, the diffractive element 20 is a dispersive element in which a transmissive type diffraction grating is formed. In the present embodiment, the diffraction grating of the diffractive element 20 satisfies a diffraction condition for emitting light beams from the plurality of laser elements 31 to 33 in the same direction and combining the light beams (details will be described later). The diffractive element 20 is not particularly limited to the transmissive type, and may be formed of a reflective type diffraction grating.

The telescope optical system 26 is formed of a plurality of cylindrical lenses having optical power in a direction corresponding to the fast axis, for example. For example, the telescope optical system 26 reduces the beam diameter in the fast axis of the light beam from the diffractive element 20 to emit the light beam to the output coupler 25. The telescope optical system 26 can reduce the angular error sensitivity of the output coupler 25 with respect to the fast axis of the light beam.

The output coupler 25 is disposed in a direction in which the light beam diffracted by the diffractive element 20 is emitted. For example, the output coupler 25 includes a mirror element with predetermined transmittance and reflectance. Among the light beams incident on the output coupler 25 from the diffractive element 20, a transmission component corresponding to the transmittance is emitted to the transmission optical system 10 as an output of the optical resonator 2, for example. On the other hand, the reflection component corresponding to the reflectance is returned to the diffractive element 20 for optical resonance. The output coupler 25 may be provided with a mechanism capable of adjusting such reflectance and transmittance.

The configuration of the optical resonator 2 as described above is an example, and is not particularly limited to this configuration. For example, the telescope optical system 26 may be omitted. Alternatively or additionally, an optical system for performing various adjustments in the optical resonator 2 may be included. The optical resonator 2 may further include various optical elements such as a half-wave plate or a prism. The number of the LD arrays 3 in the optical resonator 2 is not limited to one, and may be plural.

1-2. Collimator optical system

Details of the collimator optical system 4 in the present embodiment will be described with reference to Figs. 2 to 5.

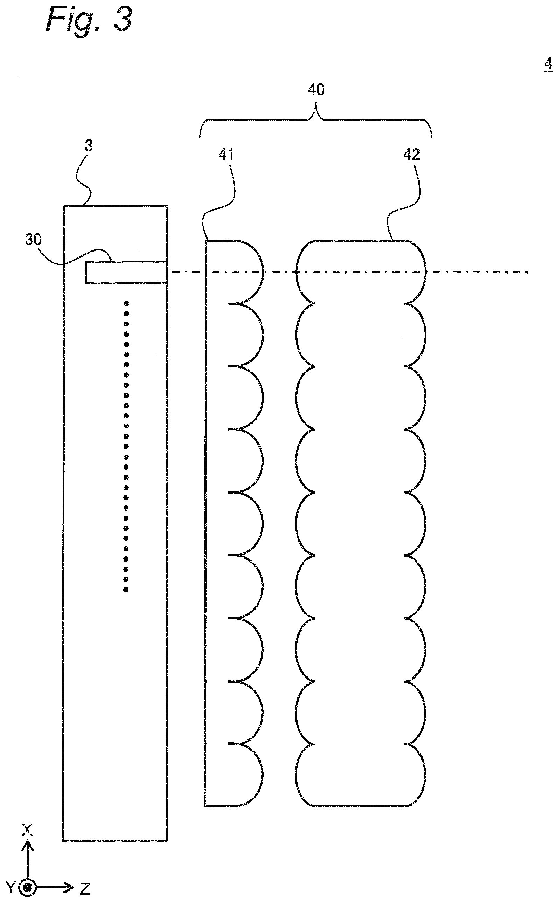

In the collimator optical system 4 of the present embodiment, the BTU 40 is disposed on the +Z side of the LD array 3, and the FAC 45 is disposed on the +Z side of the BTU 40 as shown in Fig. 2, for example. Fig. 3 illustrates the configuration of the BTU 40 in the collimator optical system 4. Fig. 3 corresponds to an XZ cross-section along the optical axis of the laser element 30 in the BTU 40.

The BTU 40 in the collimator optical system 4 includes an FAC 41 disposed facing the LD array 3 and a BT (beam twister) 42 disposed on the +Z side of the FAC 41 as shown in Fig. 3, for example. Hereinafter, the FAC 41 in the BTU 40 is referred to as a first FAC 41, and the FAC 45 outside the BTU is referred to as a second FAC 45. The first FAC 41 extends in the X direction, which is the arrangement direction of the plurality of laser elements 30 in the LD array 3.

The first FAC 41 of the present embodiment is configured in an array shape having positive optical power (i.e., positive power) for each laser element 30 arranged in the X direction. By introducing such a first FAC 41, the optical resonator 2 of the present embodiment can achieve simplification of the overall configuration of the optical system.

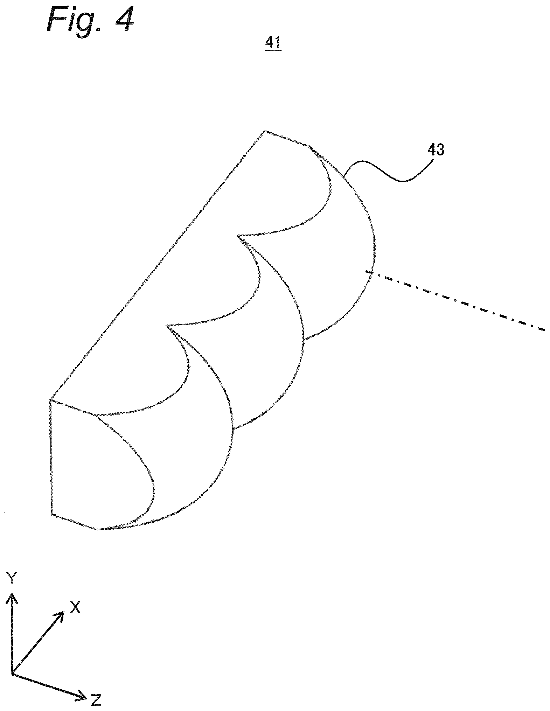

Fig. 4 is a perspective view illustrating the configuration of the first FAC 41 in the BTU 40 of the present embodiment. The first FAC 41 of the present embodiment is formed of a toroidal array and includes a plurality of lens portions 43 arranged in the X direction. The lens portion 43 is a portion constituting a lens corresponding to each laser element 30 in the first FAC 41.

For example, the plurality of lens portions 43 in the first FAC 41 have the same shape or the like and are arranged at a pitch similar to the pitch between the laser elements 30 in the LD array 3. For example, each lens portion 43 has an optical axis that coincides with the optical axis of the light beam from the corresponding laser element 30. The first FAC 41 is disposed at a focal length of each lens portion 43 from the emission side of the LD array 3, for example (cf. Fig. 3).

The first FAC 41 of the present embodiment has a lens shape in which the positive power in the X direction is smaller than the positive power in the Y direction in each lens portion 43 according to the characteristics of a fast axis Af and a slow axis As of the laser element 30. The lens portion 43 of the first FAC 41 is an example of the first lens portion 43 in the present embodiment.

In the configuration example of Fig. 4, the lens surface from which the light beam is emitted on the +Z side in the first FAC 41, that is, the emission surface, is configured as a toroidal aspherical surface for each lens portion 43. Such an emission surface of the first FAC 41 is rotationally asymmetric with respect to each optical axis for each lens portion 43.

In the present configuration example, the lens surface on which the light beam is incident from the laser element 30 on the -Z side of the first FAC 41, that is, the incident surface, is a flat surface. According to the present configuration example, it is possible to omit the processing for axial alignment between the incident surface and the emission surface, and to facilitate the manufacturing of the first FAC 41. Numerical examples of such a first FAC 41 will be described later.

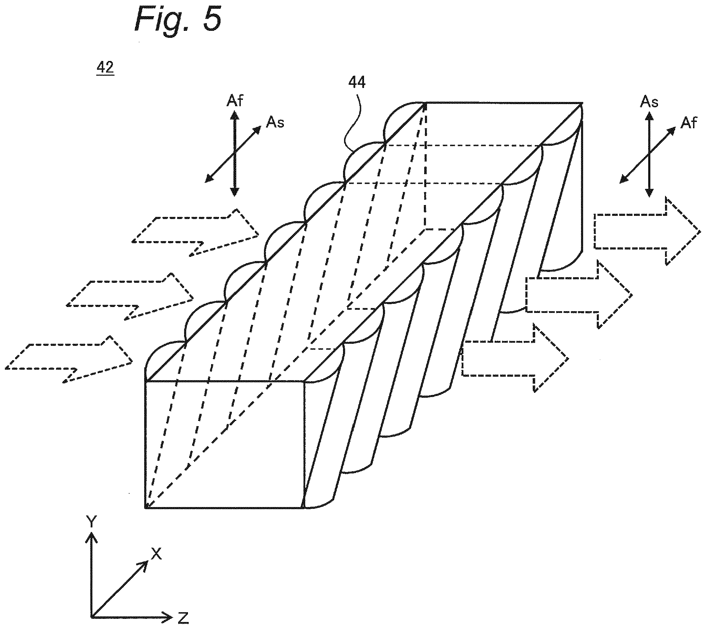

Fig. 5 is a perspective view showing a configuration example of the BT 42. For example, the BT 42 is an optical element that rotates a plurality of light beams and includes a plurality of oblique lens portions 44. The oblique lens portion 44 is a portion constituting a lens for each laser element 30 in the BT 42 and constitutes a cylindrical lens, for example. The oblique lens portion 44 is an example of a second lens portion in the present embodiment. Note that the BT 42 and the first FAC 41 are not particularly limited to being integrally provided as in the BTU 40, and for example, the first FAC 41 may be provided separately from the BT 42.

The BT 42 is formed such that a plurality of oblique lens portions 44 are arranged at a predetermined pitch in the X direction, for example. The oblique lens portion 44 is inclined by 45° with respect to both the X and Y directions, for example. The inclination of the oblique lens portion 44 in BT 42 is not necessarily 45°, and may be e.g. 40° to 50° with respect to the Y direction.

For example, the BT 42 may be attached to the first FAC 41 and the LD array 3 by being rotated around the optical axis of the specific laser element 30, such as the center one, by a predetermined minute angle (e.g., 0.01° or less). This may provide the BT 42 with a light-condensing function to emit a plurality of light beams, which have passed through the BT 42, at a light beam angle that brings the light beams closer to each other as they travel (e.g., see Patent Document 1).

Returning to Fig. 2, in the collimator optical system 4 of the present embodiment, the second FAC 45 is formed of a spherical lens and has positive power, for example. For example, the second FAC 45 is disposed rotationally symmetrically around the optical axis of the light beam emitted from a specific laser element 30, such as the center one, in the LD array 3. For example, the second FAC 45 is disposed at a position with a focal length from the emission surface of the BTU 40 on the +Z side where the light beam travels, for example.

The second FAC 45 is not particularly limited to a spherical lens, and may be e.g. a rotationally symmetric aspherical lens or a rotationally asymmetric lens such as an anamorphic aspherical lens. The second FAC 45 is not limited to one lens element, and may be formed of a plurality of lens elements. For example, the second FAC 45 may be configured by combining a positive lens and a negative lens to have a combined focal length longer than the focal length of one positive lens. The second FAC 45 is not particularly limited to a refraction lens, and may be a diffraction lens.

1-2-1. Collimating functions in fast/slow axes

The function of the collimator optical system 4 of the present embodiment, which is configured as described above, to collimate each light beam from the LD array 3 will be described with reference to Figs. 6A to 8B.

Figs. 6A and 6B are diagrams for explaining the collimating function in the fast axis Af in the collimator optical system 4 of the present embodiment. Fig. 6A is a side view of the collimator optical system 4 as viewed from the X side. Fig. 6B is a side view of the collimator optical system 4 as viewed from the Y side. Figs. 6A and 6B illustrates each of the lens portions 43, 44 corresponding to the light beam from one laser element 30.

Figs. 6A and 6B illustrate a component Bf with respect to the fast axis Af of the light beam. Before the light beam of the laser element 30 is incident on the collimator optical system 4, the fast axis Af of the light beam faces the Y direction, and the slow axis As faces the X direction.

In the collimator optical system 4 of the present embodiment, as exemplified in Fig. 6A, the first FAC 41 collimates the light beam from the laser element 30 in the Y direction corresponding to the fast axis Af, and emits the collimated light beam to the BT 42.

The BT 42 rotates the light beam incident from the laser element 30 via the first FAC 41 by a rotation angle of 90 degrees on the XY plane. As a result, the fast axis Af of the light beam emitted from the BT 42 is directed in the X direction, and the slow axis As is directed in the Y direction.

As shown in Fig. 6B, the light beam emitted from BT 42 basically linearly travels to the +Z side for the component Bf corresponding to the fast axis Af. However, according to the wave action of the light, as the light beam travels to the +Z side, the beam diameter corresponding to the fast axis Af may spread due to the influence of diffraction.

Therefore, the second FAC 45 collimates the light beam with the beam diameter thus expanded on the +Z side of the BT 42, and inhibits the influence of wave diffraction on the component Bf in the fast axis Af of the light beam, for example. With such a collimating function in the fast axis Af, the collimator optical system 4 of the present embodiment can output a light beam with fine beam quality in the fast axis Af to the diffractive element 20 and the like of the optical resonator 2, for example (cf. Fig. 2).

The collimator optical system 4 of the present embodiment has the collimating function in the slow axis As in addition to the collimating function in the fast axis Af as described above. Prior to the description, a typical configuration with such a collimating function will be described (e.g., see Patent Document 1).

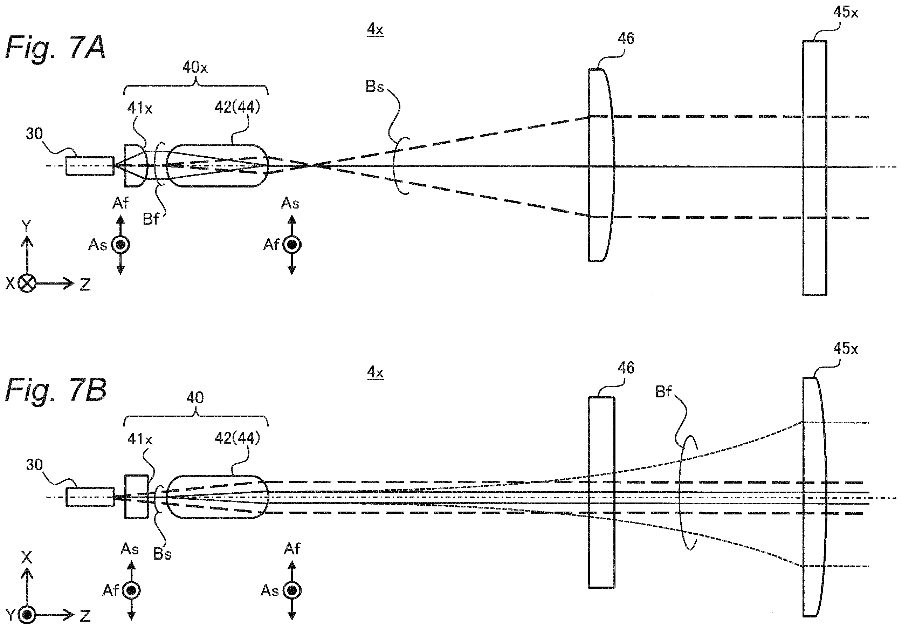

Figs. 7A and 7B are diagrams for explaining a collimator optical system 4x of the typical example described above. Fig. 7A is a side view of the collimator optical system 4x from the X side, and Fig. 7B is a side view of the collimator optical system 4x from the Y side. Figs. 7A and 7B illustrate the component Bf in the fast axis Af and a component Bs in the slow axis As of the light beam in the collimator optical system 4x.

The typical collimator optical system 4x further includes a slow-axis collimator (SAC) 46 in addition to the BTU 40x and the second FAC 45x. The typical FACs 41x, 45x are respectively different from the FACs 41, 45 in the collimator optical system 4 of the present embodiment in a configuration such as a lens shape.

For example, as shown in Figs. 7A and 7B, the typical first FAC 41x is formed of a cylindrical lens having positive power only in the Y direction corresponding to the fast axis Af. In the present example, the light beam from the laser element 30 is collimated only for the component Bf in the fast axis Af by the first FAC 41x and is incident on the BT 42. When the light beam in the typical example as described above is emitted from the BT 42, as exemplified in Fig. 7A, the component Bs in the slow axis As becomes divergent light.

For example, as shown in Figs. 7A and 7B, the SAC 46 is disposed between the BTU 40x and the FAC 45x, and is formed of a cylindrical lens having positive power only in the Y direction corresponding to the slow axis As. In the present example, the light beam from the BT 42 is collimated for the component Bs in the slow axis As by the SAC 46 and emitted to the FAC 45x.

For example, as shown in Figs. 7A and 7B, the typical second FAC 45x is formed of a cylindrical lens having positive power only in the X direction corresponding to the fast axis Af. As shown in Fig. 7B, the second FAC 45x inhibits the wave influence on light for the component Bf in the fast axis Af.

As described above, in the typical collimator optical system 4x, two FACs 41x, 45x are used for the collimating function in the fast axis Af, and one SAC 46 is used for the collimating function in the slow axis As. In such a typical configuration, achieving the collimating function in each of the axes Af, As requires accurate placement of the SAC 46 in addition to the BTU 40x and the second FAC 45x, resulting in a complicated placing configuration and an enlarged device configuration.

Therefore, in the collimator optical system 4 of the present embodiment, the SAC 46 with the typical configuration as described above is omitted, and instead, a lens shape capable of achieving the collimating function in the slow axis As is adopted for the first and second FACs 41, 45. It is thereby possible to provide the collimator optical system 4, which can simplify the placing configuration by the amount of the omitted SAC 46 while maintaining the collimating function in each of the axes Af, As, and can also be reduced in size.

Figs. 8A and 8B are diagrams for explaining the collimating function in the slow axis As in the collimator optical system 4 of the present embodiment. Figs. 8A and 8B show side views of each of the lens portions 43, 44 of the collimator optical system 4 from the X and Y sides, respectively, similarly to Figs. 6A and 6B. Figs. 8A and 8B illustrate the component Bs in the slow axis As of the light beam in the collimator optical system 4.

In the collimator optical system 4 of the present embodiment, as exemplified in Fig. 8B, the first FAC 41 in the BTU 40 is configured with a shape having positive power also in the X direction corresponding to the slow axis As. Such a first FAC 41 also has the collimating function in the slow axis As in the collimator optical system 4 of the present embodiment. That is, when the light beam from the laser element 30 is incident on the first FAC 41, the light beam is collimated for the component Bs in the slow axis As, as shown in Fig. 8B, in addition to the component Bf in the fast axis Af (Fig. 6A).

Moreover, in the collimator optical system 4 of the present embodiment, as exemplified in Fig. 6A, the second FAC 45 after emission from the BTU 40 is configured with a shape that also has positive power in the Y direction corresponding to the slow axis As. Such a configuration can solve a new problem that arises from the above modification to the typical collimator optical system 4x with respect to the collimating function in the slow axis As. This point will be described below.

In the collimator optical system 4 of the present embodiment, the light beam incident on the BT 42 from the first FAC 41 is emitted with the slow axis As in the Y direction from the BT 42 due to the rotation of each of the axes Af, as described the above, as exemplified in Fig. 8A. The component Bs of the light beam emitted from the BT 42 in this manner is collimated in the slow axis As in the first FAC 41 before incidence on the BT 42 (Fig. 8B), resulting in the light beam being geometrically and optically parallel to the Z direction.

However, in the case of collimation before incidence on the BT 42 as described above, as shown in Fig. 8A, the wave diffraction of light may also affect the component Bs in the slow axis As of the light beam on the +Z side after emission of the BT 42. For this reason, even though collimation in the slow axis As has been performed once, the beam diameter in the slow axis As continues to expand toward the +Z side, which may cause the new problem that it is difficult to supply a light beam with a small diameter to the diffractive element 20 and the like.

Therefore, as shown in Fig. 8A, the collimator optical system 4 of the present embodiment collimates the light beam again also in the Y direction of the slow axis As by the second FAC 45 on the emission side of the BT 42. According to this, the collimator optical system 4 of the present embodiment can reduce the spread of the wave light beam diameter in the slow axis As and solve the above problem.

According to the collimation of the first FAC 41 in the present embodiment, the wave source at which the beam diameter in the slow axis As begins to expand as described above is located in the vicinity of the emission surface of the BT 42 and can coincide with the position of the wave source of the fast axis Af as shown in Fig. 8A (cf. Fig. 6B). Therefore, the second FAC 45 in the present embodiment can adopt a rotationally symmetric lens shape in which the position of such a wave source is the focal position, and can be achieved with a simple configuration. Note that the second FAC 45 may have a rotationally asymmetric lens shape, such as an anamorphic aspherical surface.

In the collimator optical system 4 of the present embodiment, the second FAC 45 is disposed as close to the BT 42 as the position where the SAC 46 is disposed in the typical collimator optical system 4x from the viewpoint of reducing the beam diameter in the slow axis As, for example. This enables the collimator optical system 4 to be configured in a smaller size, which in turn enables the optical resonator 2 to be reduced in size. Furthermore, it is easy to reduce the beam diameter not only in the slow axis As but also in the fast axis Af.

2. Operations

The operations of the laser processing device 1 and the optical resonator 2 configured as described above will be described below.

The laser processing device 1 (Fig. 1) of the present embodiment drives the LD array 3 of the optical resonator 2, based on an oscillation condition set in the controller 12, and causes the optical resonator 2 to generate laser light, for example. The laser processing device 1 performs various kinds of laser processing by irradiating the processing object 15 with the laser light generated by the optical resonator 2 from the processing head 11 under the control of the controller 12, for example.

For example, in the laser processing device 1 as described above, the collimator optical system 4 of the optical resonator 2 collimates a plurality of light beams from the LD array 3 by the collimating functions in the fast axis Af and the slow axis As described above, and supplies the light beams to the diffractive element 20.

The diffractive element 20 diffracts the light so that, when light with a wavelength $\lambda$ is incident at an incident angle $\alpha$, the light is emitted at a diffraction angle $\beta$, according to the diffraction condition as in the following equation (1) as an example, thereby combining the plurality of light beams from each LD array 3.

$$\sin\alpha + \sin\beta = m\lambda/d \dots (1)$$

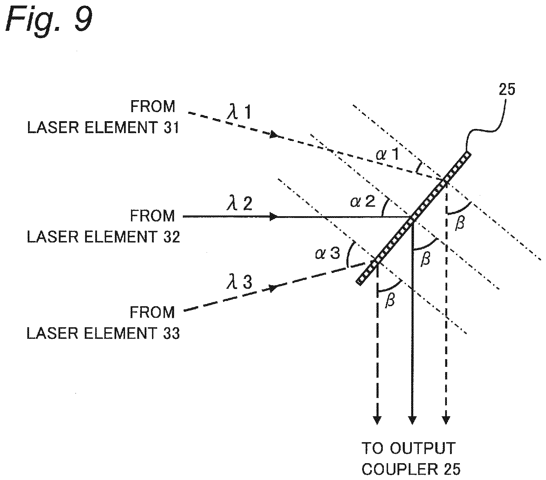

where d represents a pitch of the diffractive element 20, and m represents a diffraction order. Fig. 9 is a diagram illustrating a method of combining light beams in the diffractive element 20 of the optical resonator 2.

In the diffractive element 20, as exemplified in Fig. 9, the incident angles $\alpha = \alpha1, \alpha2, \alpha3$ of the light beams from the respective laser elements 31, 32, 33 are different from each other. In the optical resonator 2 of the present embodiment, different resonance wavelengths $\lambda = \lambda1, \lambda2, \lambda3$ are set for the respective laser elements 31, 32, 33 based on the exemplified equation (1) as the above, so that the diffraction angles $\beta$ of the light beams are the same. As a result, the plurality of light beams from the LD array 3 are emitted from the diffractive element 20 in the same direction after diffraction in the optical path illustrated in Fig. 9.

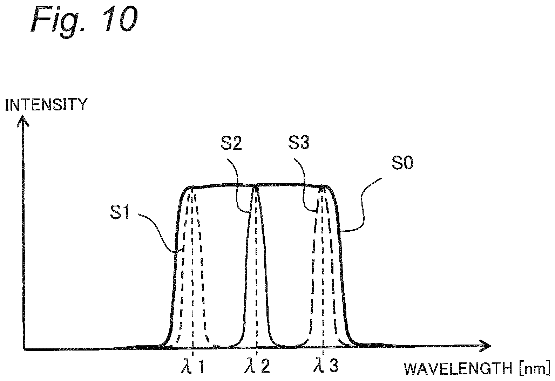

Fig. 10 is a graph showing a spectrum of the resonance wavelength $\lambda$ in the optical resonator 2. In the graph of Fig. 10, the horizontal axis represents the wavelength and the vertical axis represents the intensity of light.

Fig. 10 shows resonance spectra S1 to S3 of the plurality of laser elements 31 to 33 in the LD array 3 and a common spontaneous emission spectrum S0. The resonance spectra S1, S2, S3 indicate distributions of the resonance wavelengths $\lambda$ of the respective LDs 31, 32, 33. The spontaneous emission spectrum S0 includes a specific wavelength band, e.g. a blue region. The light beam thus combined is incident on the output coupler 25 via the telescope optical system 26, for example.

The output coupler 25 reflects a part of the light beam combined by the diffractive element 20 to move the reflected light beam back through the telescope optical system 26 and the like, thus returning the light beam to each laser element 30. For example, due to the backward movement along the optical path illustrated in Fig. 9, the light beams with the plurality of wavelengths $\lambda = \lambda1$ to $\lambda3$ are separated and emitted at different angles $\alpha1, \alpha2, \alpha3$ for the respective wavelengths $\lambda1, \lambda2, \lambda3$ in the diffractive element 20, similarly to the angles $\alpha$ of incidence on the diffractive element 20 from the respective laser elements 31, 32, 33. The separated light beams further move back through the collimator optical system 4 and the like, and are returned to the laser elements 31, 32, 33 of the incident sources, respectively.

Thus, in the optical resonator 2, return light for laser oscillation is supplied over various resonance wavelengths $\lambda = \lambda1$ to $\lambda3$, enabling optical resonance to occur between the rear end surface of the LD array 3 and the output coupler 25. The light beam having passed through the output coupler 25 is used as an output of the laser processing device 1, for example.

2-1. Numerical simulation for light spot

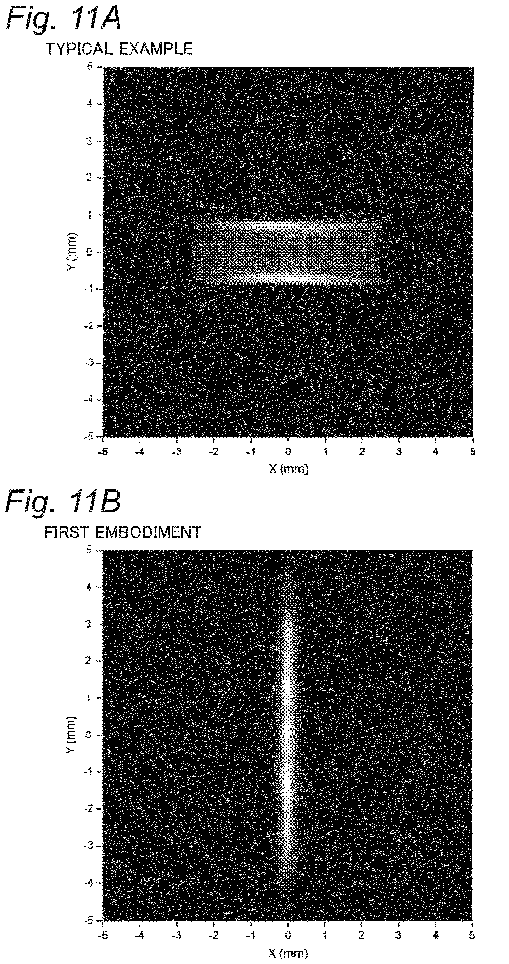

By a numerical simulation for a light spot that is a spot of a light beam obtained by the optical resonator 2 in the laser processing device 1 as described above, the effect of the collimator optical system 4 of the present embodiment can be verified. Such a numerical simulation will be described with reference to Figs. 11A and 11B.

Figs. 11A and 11B are diagrams for explaining a numerical simulation for a light spot in the present embodiment. Fig. 11A shows a simulation result of the collimator optical system 4x of the typical example. Fig. 11B shows a simulation result of the collimator optical system 4 of the present embodiment.

In Figs. 11A and 11B, a numerical simulation is performed for a light spot formed by a light beam from one laser element 30 in the LD array 3. In this simulation, the numerical calculation of the light spot is performed for the collimator optical system 4x (Figs. 7A and 7B) of the typical example including the typical FACs 41x, 45x and the collimator optical system 4 of the present embodiment including the FACs 41, 45.

Figs. 11A and 11B each show a two-dimensional distribution of light intensity obtained as a simulation result of a light spot formed on the incident surface of the diffractive element 20. In Figs. 11A and 11B, the horizontal axis indicates the position in the X direction corresponding to the fast axis Af, and the vertical axis indicates the position in the Y direction corresponding to the slow axis As, each in mm. In the drawings, the magnitude of the light intensity is shown by shading, with a substantially white portion indicating the light spot.

As shown in Fig. 11B, the collimator optical system 4 of the present embodiment was checked that the size of the light spot (i.e., beam diameter) can be made smaller in the X direction, i.e. in the fast axis Af, than in the case of Fig. 11A. Thus, it is possible to improve the beam quality in the wavelength-combining optical resonator 2.

Also, for the Y direction, i.e. the slow axis As, a result was obtained in which the beam diameter (Fig. 11B) in the present embodiment is comparable to the beam diameter (Fig. 11A) in the typical example. That is, it can be verified that the collimator optical system 4 of the present embodiment can solve the new problem regarding the collimating function in the slow axis As described above and supply a light beam with a sufficiently small diameter to the diffractive element 20.

Moreover, according to the collimator optical system 4 of the present embodiment, as the beam diameter can be reduced in the direction of the fast axis Af as described above, the configuration of the optical resonator 2 can be further simplified. For example, in the telescope optical system 26 on the emission side from the diffractive element 20, it is not necessary to reduce the light spot particularly in the direction of the fast axis Af, and the telescope optical system 26 can be omitted.

2-2. Numerical examples

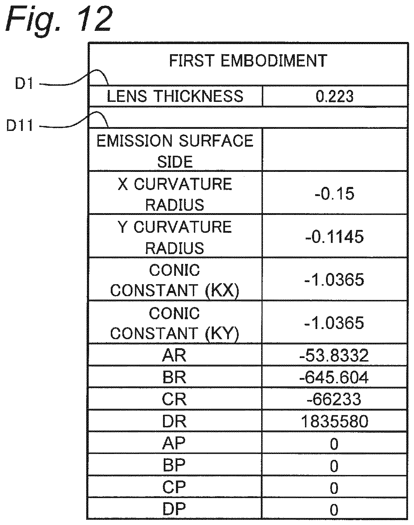

A numerical example of the first FAC 41 in the collimator optical system 4 of the present embodiment as described above will be described with reference to Fig. 12.

Fig. 12 is a table showing a numerical example in the collimator optical system 4 of the present embodiment. The table of Fig. 12 includes lens thickness data D1 and emission surface data D11 for the first FAC 41 of the present embodiment. Note that the incident surface of the first FAC 41 of the present embodiment is a flat surface as described above.

The lens thickness data D1 indicates the thickness of the lens portion 43 of the first FAC 41 in the Z direction. The table of Fig. 12 shows various dimensions related to the length of one lens portion 43 in the first FAC 41. For example, millimeters are used as the unit of length, such as lens thickness.

The emission surface data D11 defines the shape of the emission-side lens surface of the lens portion 43 in the first FAC 41. For example, as shown in Fig. 12, the emission surface data D11 of the present embodiment includes an X curvature radius, a Y curvature radius, conic constants KX, KY in the X and Y directions, rotationally symmetric deformation coefficients AR, BR, CR, DR, and non-rotationally symmetric deformation coefficients AP, BP, CP, DP. The X curvature radius is the curvature radius of the lens portion 43 in the X direction. The Y curvature radius is the curvature radius of the lens portion 43 in the Y direction. For example, each curvature radius is measured in the vicinity of a vertex in a cross-section passing through the optical axis of the lens portion 43. The emission surface of the first FAC 41 of the present embodiment constitutes an anamorphic aspherical surface defined by the following equation (2) for each lens portion 43.

[Equation 1]

$$z = \frac{CUXx^2 + CUYy^2}{\begin{array}{l}1 + \sqrt{1 - (1+KX)CUX^2x^2 - (1+KY)CUY^2y^2} \\ + AR\{(1-AP)x^2 + (1+AP)y^2\}^2 \\ + BR\{(1-BP)x^2 + (1+BP)y^2\}^3 \\ + CR\{(1-CP)x^2 + (1+CP)y^2\}^4 \\ + DR\{(1-DP)x^2 + (1+DP)y^2\}^5\end{array}} \quad \cdots(2)$$

In the above equation (2), x and y represent positions on the lens surface in the X and Y directions, respectively, and z represents a sag amount of the lens surface in the Z direction. CUX represents curvature in the X direction and corresponds to the X curvature radius. CUY represents curvature in the Y direction and corresponds to the Y curvature radius.

The FAC 41 of the present embodiment is a toroidal array that satisfies the above equation (2) for each lens portion 43. The emission-side lens surface of such a lens portion 43 is a rotationally asymmetric convex surface, that is, convex on the +Z side in each of the X and Y directions, and the convex shapes are different from each other.

In the first FAC 41 of the present embodiment, as exemplified in Fig. 12, the absolute value of the X curvature radius is larger than the absolute value of the Y curvature radius on the emission surface, that is, the positive power in the X direction is smaller than the positive power in the Y direction. Such a first FAC 41 makes it possible to facilitate collimation corresponding to the characteristics of the fast axis Af and the slow axis As of the laser element 30.

3. Summary

As described above, the collimator optical system 4 in the present embodiment is an example of an optical system that guides a plurality of light beams from the LD array 3, which is an example of a light source array where the laser elements 30 as a plurality of light sources are arranged. The collimator optical system 4 includes the first FAC 41, which is an example of a first collimator lens, the BT 42, which is an example of an optical element, and the second FAC 45, which is an example of a second collimator lens. The first FAC 41 is disposed facing the LD array 3, and collimates each light beam in at least the Y direction out of the X direction and the Y direction. The Y direction is an example of the arrangement direction of the plurality of laser elements 30. The Y direction is an example of the vertical direction intersecting the X direction and the Z direction, which is an example of the optical axis direction of each light beam. The BT 42 is disposed on the emission side (+Z side) of each light beam in the FAC 41. The second FAC 45 is disposed on the emission side of each light beam in the BT 42, and collimates each light beam at least in the X direction. The first FAC 41 includes a plurality of lens portions 43 arranged in the X direction corresponding to the plurality of laser elements 30 in the LD array 3. Each of the plurality of lens portions 43 is provided rotationally asymmetrically to have positive power in the Y direction and positive power in the X direction.

According to the collimator optical system 4 described above, by introducing the first FAC 41 that constitutes the toroidal array with the lens portions 43 having positive power also in the X direction, it is possible to facilitate simple configuration of the optical system that guides the plurality of light beams from the LD array 3.

In the present embodiment, the light beam of the LD array 3 is emitted from each laser element 30 in a state where the divergence angle in the X direction corresponding to the fast axis Af is smaller than the divergence angle in the Y direction corresponding to the slow axis As (cf. Figs. 6A and 8B). In each lens portion 43 of the first FAC 41, the positive power in the X direction is smaller than the positive power in the Y direction.

According to the collimator optical system 4 described above, the first FAC 41 can guide the light beam with positive power smaller than that in the X direction in the Y direction corresponding to the slow axis As in accordance with the characteristic that the divergence angle of the component Bs in the slow axis As is smaller than that of the component Bf in the fast axis Af in the light beam from the laser element 30. As described above, the light beams can be guided from the first FAC 41 in accordance with the characteristic of the divergence angle different between the two axes Af, As, and it is possible to facilitate simplification of the configuration of the optical system for the light source array such as the LD array 3.

In the present embodiment, the second FAC 45 has positive power in the X direction and positive power in the Y direction. This also enables the second FAC 45 to perform the light guide, such as collimation, of the light beam not only in the fast axis Af but also in the slow axis As, and facilitates simplification of the configuration of the collimator optical system 4.

In the present embodiment, the second FAC 45 is provided rotationally symmetrically in the Z direction, and is disposed at a focal length from the emission-side surface of the BT 42. It is thereby possible to simply configure the second FAC 45 that collimates the light beam in the fast axis Af and the slow axis As, and simplify the configuration of the collimator optical system 4.

In the present embodiment, the first FAC 41 is disposed to collimate each light beam from the LD array 3 in the Y direction and the X direction. The second FAC 45 is disposed to collimate each light beam from the BT 42 in the X direction and the Y direction. As a result, in both the fast axis Af and the slow axis As, the first FAC 41 collimates each light beam, and the second FAC 45 collimates each light beam that can spread due to the wave influence of light from the BT 42, so that the beam quality of the light beam output from the collimator optical system 4 can be improved.

In the present embodiment, the BT 42 rotates each light beam incident from the first FAC 41 around the Z direction. This enables the collimator optical system 4 to output the light beam such that the wavelengths of the plurality of light beams can be combined in the fast axis Af with the fine beam quality with the fast axis Af of the light beam directed in the X direction of the arrangement direction of the light beams.

In the present embodiment, the surface of the first FAC 41 on the emission side of each light beam has a convex shape in the Y direction and a convex shape in the X direction, which is different from the convex shape in the Y direction, for each lens portion 43. It is thereby possible to control the light guide of the light beam rotationally asymmetrically for each lens portion 43 on the emission surface of the first FAC 41, achieving simplification of the configuration of the collimator optical system 4 as a whole.

In the present embodiment, the surface of the first FAC 41 on the incident side of each light beam is a flat surface. This makes it possible to omit the processing for, in particular, axis alignment between the incident surface and the emission surface, and the like, in the first FAC 41 and simplify the manufacturing of the first FAC 41.

In the present embodiment, for example, a laser device such as the optical resonator 2 includes the LD array 3 including a plurality of laser elements 30 that are arranged in the X direction and emit a plurality of light beams, and a collimator optical system 4 that guides the plurality of light beams from the LD array 3. According to such a laser device, the first FAC 41 of the collimator optical system 4 can facilitate simple configuration of the optical system in the laser device using the LD array 3.

In the present embodiment, the optical resonator 2, which is an example of a laser device, further includes the diffractive element 20 and the output coupler 25. The diffractive element 20 diffracts each light beam at an angle corresponding to the wavelength of each light beam guided from the LD array 3 in the optical system. The output coupler 25 reflects a part of the light beam diffracted by the diffractive element 20 back to the laser element 30, and outputs the rest of the light beam. In such an optical resonator 2, the first FAC 41 of the collimator optical system 4 can facilitate simply configuring the optical system.

In the present embodiment, the laser processing device 1, which is a further example of the laser device, further includes the processing head 11 that irradiates a processing object with the light beam output from the output coupler 25 of the optical resonator 2, in addition to the configuration of the optical resonator 2. In such a laser processing device 1, the first FAC 41 of the collimator optical system 4 can facilitate simple configuration of the optical system.

In the present embodiment, the first FAC 41 is an example of a collimator lens that collimates a plurality of light beams from the LD array 3 in which a plurality of laser elements 30 is disposed. The first FAC 41 includes the lens portion 43 as an example of a plurality of first lens portions arranged in the X direction corresponding to the plurality of laser elements 30 in the LD array 3. Each of the plurality of lens portions 43 is provided rotationally asymmetrically to have positive power in the Y direction and positive power in the X direction. Such a first FAC 41 makes it possible to facilitate simple configuration of various optical systems that guide the plurality of light beams from the light source array such as the LD array 3.

In the present embodiment, the BTU 40 is an example of an optical system including the first FAC 41 and the BT 42 that is disposed on the emission side of each light beam in the first FAC 41. The BT 42 includes the oblique lens portions 44 as an example of a plurality of second lens portions arranged to rotate the respective light beams incident from the first FAC 41 around the Z direction. Such a BTU 40 can also facilitate simple configuration of an optical system that guides a plurality of light beams from the LD array 3 and the like.

In the present embodiment, there may be provided a laser device equipped with the LD array 3 including a plurality of laser elements 30 that are arranged in the X direction and emit a plurality of light beams, and the first FAC 41 that guides the plurality of light beams from the LD array 3. For example, a laser module with the BTU 40 assembled to the LD array 3 may be provided. In such a laser module, the BT 42 may be omitted. Even in various systems using such a laser module, the first FAC 41 can facilitate simple configuration of the optical system.

(Second Embodiment)

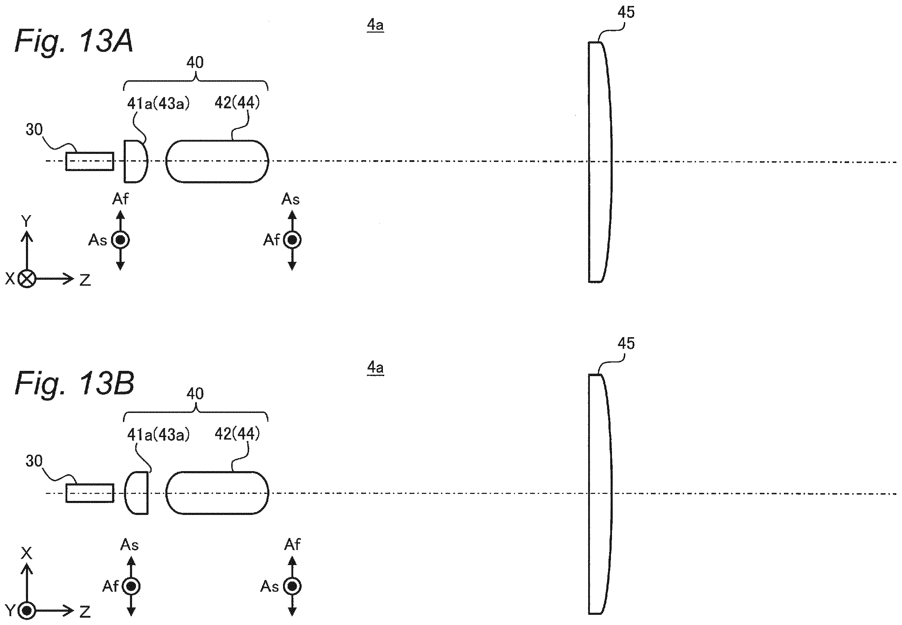

A second embodiment will be described below with reference to Figs. 13A to 16. In the first embodiment, the example in which the incident surface of the first FAC 41 in the collimator optical system 4 is a flat surface has been described. In the second embodiment, a collimator optical system with an incident surface of a first FAC having positive power will be described.

Hereinafter, the collimator optical system and the first FAC according to the present embodiment will be described, omitting, as appropriate, description of configurations and operations similar to those of the laser processing device 1 and the laser device such as the optical resonator 2, the optical system such as the collimator optical system 4, and the first FAC 4 according to the first embodiment.

Figs. 13A and 13B illustrate a configuration of a collimator optical system 4a according to the second embodiment. Figs. 13A and 13B show side views of the collimator optical system 4a of the present embodiment from the X and Y sides, respectively, similarly to Figs. 6A and 6B and other drawings. The collimator optical system 4a of the present embodiment includes a first FAC 41a with a shape of a lens portion 43a different from that of the lens portion 43 of the first embodiment in a configuration similar to that of the collimator optical system 4 of the first embodiment.

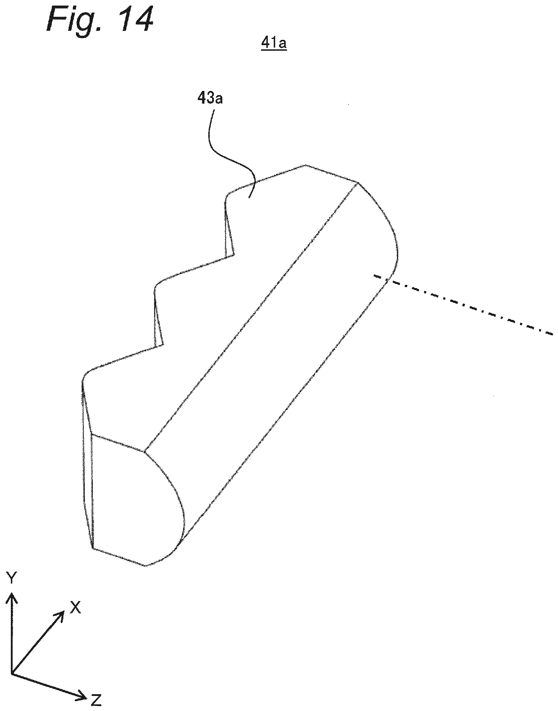

Fig. 14 illustrates the configuration of the first FAC 41a in the second embodiment. In the first FAC 41a of the present embodiment, the incident surface on the -Z side is formed of a cylindrical surface having positive power in the X direction and not having optical power in the Y direction for each lens portion 43a. The emission surface on the +Z side of the first FAC 41a of the present embodiment is formed of a cylindrical surface having positive power in the Y direction and not having optical power in the X direction.

The first FAC 41a configured as described above has the collimating function in the slow axis As on the incident surface and the collimating function in the fast axis Af on the emission surface. Such a configuration also omit the processing for axial alignment between the incident surface and the emission surface in the first FAC 41a, and can facilitate the manufacturing of the first FAC 41a.

Returning to Figs. 13A and 13B, in the collimator optical system 4a of the present embodiment, the second FAC 45 may have a shorter focal length than the second FAC 45 of the first embodiment. The second FAC 45 is disposed closer to the emission surface of the BT 42 by the reduced focal length, for example.

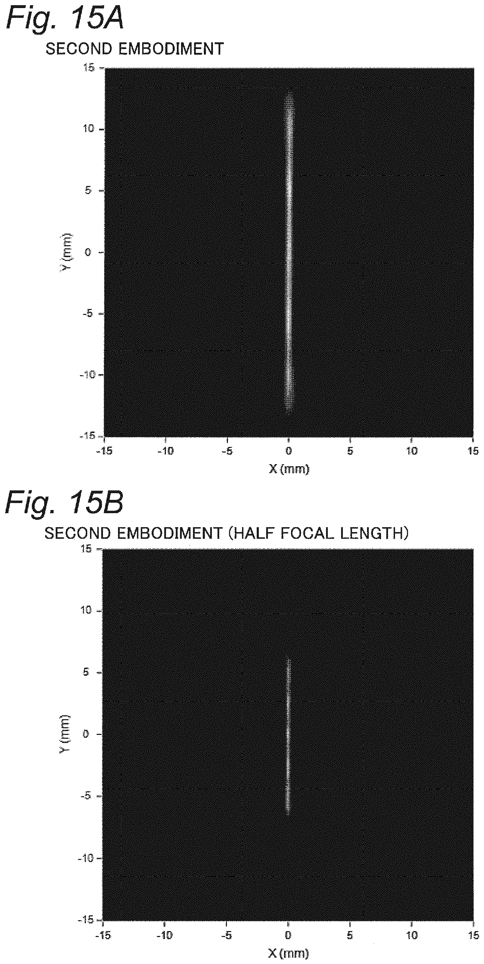

Figs. 15A and 15B are diagrams for explaining a numerical simulation for a light spot in the collimator optical system 4a of the second embodiment. Fig. 15A illustrates a case where the focal length of the second FAC 45 in the collimator optical system 4a of the present embodiment is similar to that of the first embodiment. Fig. 15B illustrates a case where the focal length of the second FAC 45 is reduced by half from Fig. 15A.

As shown in Figs. 15A and 15B, it can be verified that the collimator optical system 4a of the present embodiment can also obtain a light beam with a sufficiently small light spot, similarly to the first embodiment. For example, as shown in Fig. 15B, reducing the focal length of the second FAC 45 enables a sufficient reduction in the size of the light spot in the Y direction (slow axis As), similarly to the first embodiment and the like.

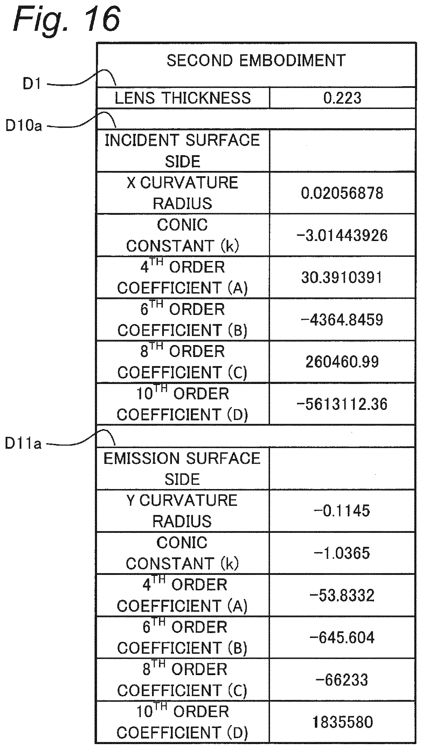

Fig. 16 is a table showing a numerical example in the collimator optical system 4a of the second embodiment. The table of Fig. 16 includes lens thickness data D1, incident surface data D10a, and emission surface data D11a for the first FAC 41a of the present embodiment, which are similar to those of the first embodiment.

The incident surface data D10a of the present embodiment includes an X curvature radius, a conic constant k, and various aspherical coefficients A, B, C, and D, for the incident-side lens surface of the lens portion 43a in the first FAC 41a as shown in Fig. 16, for example. The conic constant k and the various aspherical coefficients A to D represent various coefficients of the following equation (3) that defines the shape of the aspherical surface.

[Equation 2]

$$z = \frac{cr^2}{1 + \sqrt{1 - (1 + k)c^2 r^2}} + Ar^4 + Br^6 + Cr^8 + Dr^{10} \qquad \cdots (3)$$

In the above equation (3), z is the sag amount of the lens surface, r is the distance on the lens surface with respect to a reference position, and c is curvature at the vertex of the lens surface. In the above equation (3), the aspherical coefficients A to D of the order of 4 to 10 are used, but higher-order aspherical coefficients may be used. For example, in an axisymmetric aspherical surface, the sag amount z indicates displacement parallel to the Z direction, and the distance r indicates displacement in the radial direction with a position where the optical axis passes through the XY plane as the reference position.

For example, the lens portion 43a of the present embodiment satisfies equation (3) for the aspherical surface with the incident surface data D10a in each XZ cross-section. That is, the shape of the entire incident-side lens surface of the lens portion 43a is obtained by setting the same shape in the XZ cross-section at each position in the Y direction. As shown in Fig. 14, the incident-side lens surface of such a lens portion 43a is convex on the -Z side in the X direction.

The emission surface data D11a of the present embodiment includes a Y curvature radius and various coefficients k, A to D of equation (3), for the emission surface of the first FAC 41a. For example, the emission surface of the first FAC 41a of the present embodiment satisfies equation (3) for the aspherical surface with the emission surface data D11a in each YZ cross-section. As shown in Fig. 14, the emission surface of such a first FAC 41a is convex on the +Z side in the Y direction. The first FAC 41a of the present embodiment is also a toroidal array that is rotationally asymmetric for each lens portion 43a.

As described above, in the collimator optical system 4a of the present embodiment, in the first FAC 41a, the incident-side surface of each light beam has a convex shape for each lens portion 43a in the X direction. In the first FAC 41a, the emission-side surface of each light beam has a convex shape in the Y direction. The incident-side surface may have a cylindrical shape extending in the Y direction for each lens portion 43a. The emission-side surface may have a cylindrical shape extending in the X direction. Similarly to the first embodiment, such a first FAC 41a can also facilitate simple configuration of an optical system that guides a plurality of light beams from the LD array 3 and the like.

(Third Embodiment)

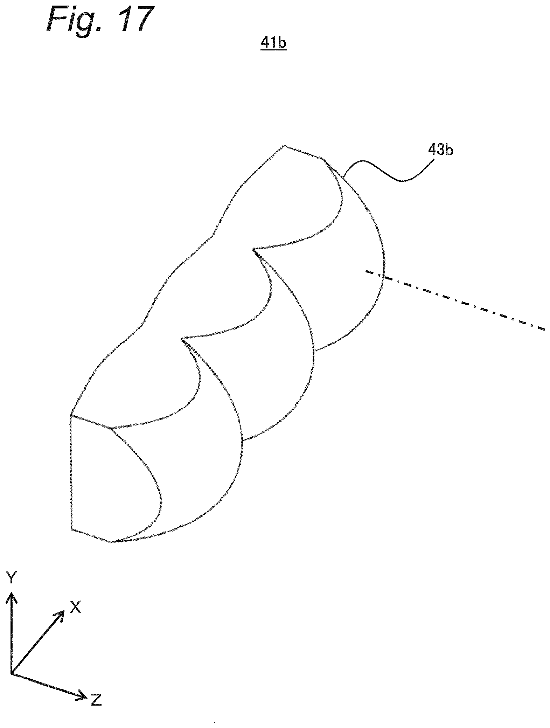

Hereinafter, a third embodiment will be described with reference to Figs. 17 to 19. In the first and second embodiments, the first FACs 41, 41a with only one of the emission surface and the incident surface having positive power in the X direction have been described. In the third embodiment, a collimator optical system with both an incident surface and an emission surface of a first FAC having positive power in the X direction will be described.

Hereinafter, the collimator optical system and the first FAC according to the present embodiment will be described, omitting, as appropriate, description of configurations and operations similar to those of various laser devices, optical systems, and the like according to the first and second embodiments.

Fig. 17 illustrates a configuration of a first FAC 41b of the third embodiment. The first FAC 41b of the present embodiment includes a lens portion 43b with a convex shape in the X direction on the incident side in a configuration similar to that of the first FAC 41 (Fig. 4) of the first embodiment, for example.

For example, the lens portion 43b of the present embodiment has a toroidal aspherical configuration on the emission side, similarly to the first embodiment, and has a cylindrical surface configuration on the incident side, similarly to the second embodiment. Such a first FAC 41b has the collimating function in the slow axis As with the incident surface and the emission surface, and has the collimating function in the fast axis Af with the emission surface.

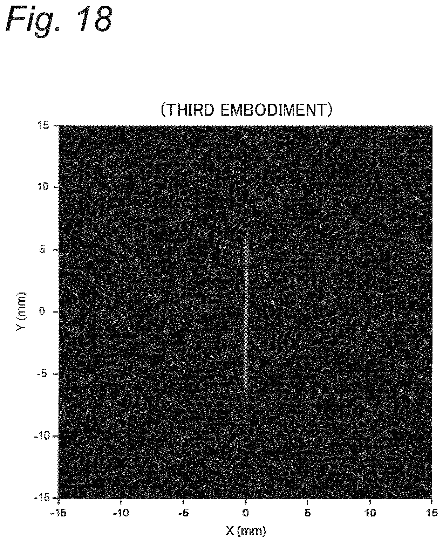

Fig. 18 is a diagram for explaining a numerical simulation for a light spot in the collimator optical system of the third embodiment. The collimator optical system of the present embodiment includes the first FAC 41b instead of the first FAC 41 of the first embodiment in a configuration similar to that of the first embodiment, for example. In the simulation of Fig. 18, such a first FAC 41b and the second FAC 45 with the focal length similar to that of the first embodiment are used to perform numerical calculation of the light spot, similarly to each of the above embodiments. As shown in Fig. 18, it can be verified that the collimator optical system of the present embodiment can also obtain, with the first FAC 41b, a similar effect to those of the first embodiment and the like with respect to the size of the light spot.

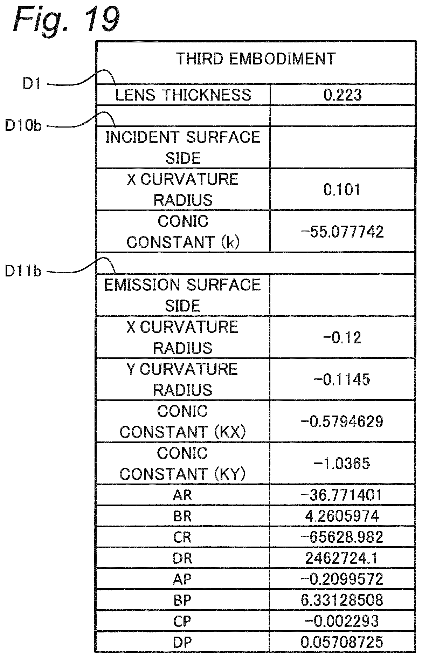

Fig. 19 is a table showing a numerical example in the collimator optical system of the third embodiment. The table of Fig. 19 includes lens thickness data D1, incident surface data D 10b, and emission surface data D11b for the first FAC 4b of the present embodiment, which are similar to those of the first and second embodiments.

In the lens portion 43b of the present embodiment, the incident surface data D10b includes an X curvature radius and a conic constant k as shown in Fig. 19, for example. The incident surface of the first FAC 41b in the present embodiment satisfies equation (3) for the aspherical surface for each lens portion 43b, similarly to the incident surface of the second embodiment with coefficients A to D set to 0 except for the conic constant k in equation (3), for example.

In the present embodiment, as exemplified in Fig. 19, the emission surface data D11b includes an X curvature radius, a Y curvature radius, conic constants KX, KY in the X and Y directions, rotationally symmetric deformation coefficients AR, BR, CR, DR, and non-rotationally symmetric deformation coefficients AP, BP, CP, DP. The emission surface of the first FAC 41b of the present embodiment satisfies equation (2) for the anamorphic aspherical surface for each lens portion 43b, similarly to the emission surface of the first embodiment. The first FAC 41b of the present embodiment is also a toroidal array that is rotationally asymmetric for each lens portion 43b.

As described above, in the present embodiment, the surface of the first FAC 41b on the incident side of each light beam has a convex shape for each lens portion 43b in the X direction. The incident-side surface may have a cylindrical shape extending in the Y direction for each lens portion 43b. Similarly to the first and second embodiments, such a first FAC 41b can also facilitate simple configuration of an optical system that guides a plurality of light beams from the light source array.


(Fourth Embodiment)

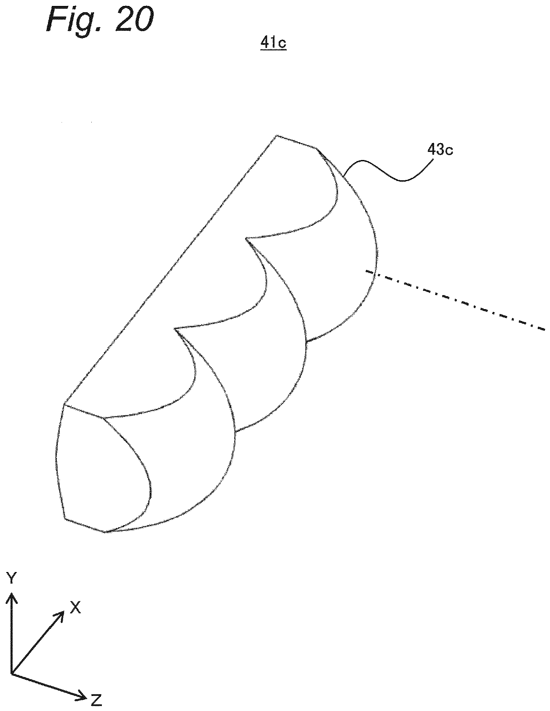

A fourth embodiment will be described below with reference to Figs. 20 to 22. In the third embodiment, the first FAC 41b with the incident surface having positive power in the X direction has been described. In the fourth embodiment, a collimator optical system with the incident surface of the first FAC having positive power in the Y direction will be described.

Hereinafter, the collimator optical system and the first FAC according to the present embodiment will be described, omitting, as appropriate, description of configurations and operations similar to those of various laser devices, optical systems, and the like according to the first to third embodiments.

Fig. 20 illustrates a configuration of a first FAC 41c of the fourth embodiment. The first FAC 41c of the present embodiment includes a lens portion 43b with a convex shape in the Y direction on the incident side in a configuration similar to that of the first FAC 41 (Fig. 4) of the first embodiment, for example.

For example, the lens portion 43c of the present embodiment has a toroidal aspherical configuration on the emission side, similarly to the first embodiment, and has a cylindrical surface configuration on the incident side, similarly to the emission surface of the second embodiment. Such a first FAC 41c has the collimating function in the fast axis Af with the incident surface and the emission surface, and has the collimating function in the slow axis As with the emission surface.

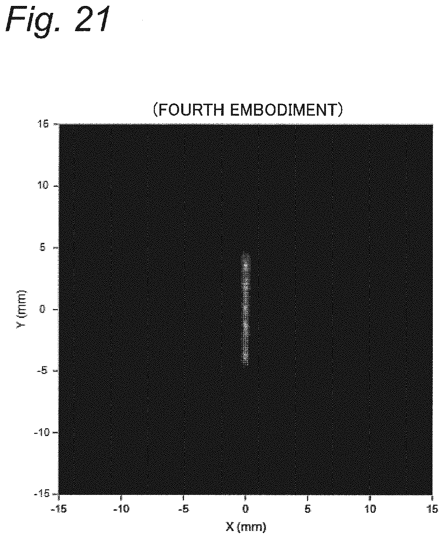

Fig. 21 is a diagram for explaining a numerical simulation for a light spot in the collimator optical system of the fourth embodiment. The collimator optical system of the present embodiment includes the first FAC 41c instead of the first FAC 41 of the first embodiment in a configuration similar to that of the first embodiment, for example. In the simulation of Fig. 21, such a first FAC 41c and the second FAC 45 with the focal length similar to that of the first embodiment are used to perform numerical calculation of the light spot, similarly to each of the above embodiments. As shown in Fig. 21, it can be verified that the collimator optical system of the present embodiment can also obtain, with the first FAC 41c, a similar effect to those of the first embodiment and the like with respect to the size of the light spot.

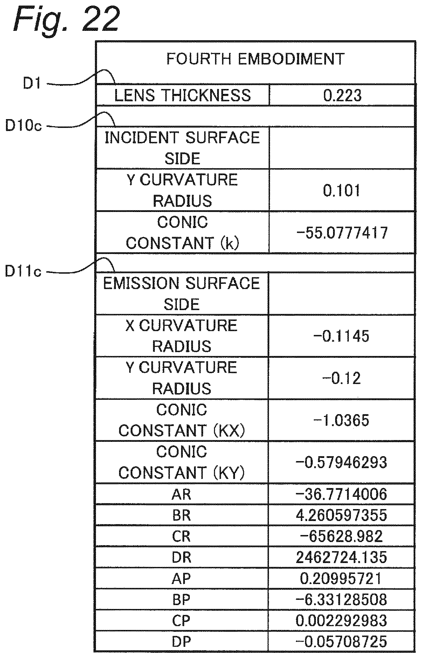

Fig. 22 is a table showing a numerical example in the collimator optical system of the fourth embodiment. The table of Fig. 22 includes lens thickness data D1, incident surface data D10c, and emission surface data D11c for the first FAC 4c of the present embodiment, which are similar to those of the first to third embodiments.

In the lens portion 43c of the present embodiment, the incident surface data D10c includes a Y curvature radius and a conic constant k as shown in Fig. 22, for example. The incident surface of the first FAC 41c in the present embodiment satisfies equation (3) for the aspherical surface, similarly to the emission surface of the second embodiment with coefficients A to D set to 0 except for the conic constant k in equation (3), for example.

The emission surface data D11c of the present embodiment indicates various coefficients in equation (2) for the anamorphic aspherical surface, similarly to the emission surface data D11b of the third embodiment. Similarly to each of the above embodiments, the first FAC 41c of the present embodiment is also a toroidal array that is rotationally asymmetric for each lens portion 43c. In the first FAC 41c of the present embodiment, with the incident surface not having optical power in the X direction, the axial alignment is not necessary between the incident surface and the emission surface, and manufacturing can be facilitated.

As described above, in the present embodiment, the surface of the first FAC 41c on the incident side of each light beam has a convex shape in the Y direction. The incident-side surface may have a cylindrical shape extending in the X direction. Similarly to the first to third embodiments, such a first FAC 41c can also facilitate simple configuration of the optical system that guides the plurality of light beams from the light source array.

(Other Embodiments)

As the above, the first to fourth embodiments have been described as examples of the techniques disclosed in the present application. However, the technique in the present disclosure is not limited thereto, and can also be applied to embodiments in which change, replacement, addition, omission, and the like are made as appropriate. It is also possible to combine the constituent elements described in each of the above embodiments to provide a new embodiment. Other embodiments will be described below.

In the first embodiment described above, the collimator optical system 4 has been described in which the collimation in the slow axis As (X direction) is performed in the first FAC 41, and the collimation in the slow axis As (Y direction) is performed again in the second FAC 45. The collimator optical system 4 of the present embodiment does not necessarily perform collimation in the slow axis As twice, once in the first FAC 41 and once the second FAC 45. The positive power in the X direction of the first FAC 41 and the positive power in the Y direction of the second FAC 45 may be appropriately distributed such that the collimation in the slow axis As is performed once for the first and second FACs 41, 45 as a whole. The light beam output from the collimator optical system of the present embodiment is not necessarily completely parallel light in the slow axis As, and may have a divergence angle within an appropriately allowable range. The collimation in each of the axes As and Af may be appropriately performed within a range of tolerance.

As described above, in the present embodiment, the first FAC 41 may not collimate the light beam from the laser element 30 in the X direction. The second FAC 45 may not collimate the light beam from the BT 42 in the Y direction. Even in this case, similarly to the first embodiment and the like, it is possible to facilitate simple configuration of the optical system that guides the plurality of light beam according to various specifications of the optical system into which the first FAC 41 and the like are introduced.

In the above embodiments, the BT 42 has been exemplified as an example of the optical element in the collimator optical system 4. In the present embodiment, the collimator optical system 4 may include an optical element different from the BT 42. For example, an optical element may be used which does not rotate each of the light beams from the LD array 3 and has a light-condensing function, such as emission of the plurality of light beams having passed through the optical element at a light beam angle that brings the light beams closer to each other as they travel.

In the above embodiments, the example of the laser processing device 1 using the wavelength-combining optical resonator 2 has been described. In the present embodiment, the laser processing device 1 is not particularly limited to the wavelength-combining type, and may be a spatially combining type, for example. In such a laser processing device 1 as well, the use of the first FAC 41 can facilitate simple configuration of the optical system that spatially combines a plurality of light beams from the LD array.

In the above embodiments, the example in which the resonance wavelength band of the optical resonator 2 is the blue region has been described. In the present embodiment, the resonance wavelength band of the optical resonator 2 is not limited to the above, and may be, for example, a red region, such as a wavelength of 900 nm to 950 nm.

As described above, the embodiments have been described as examples of the technique in the present disclosure. For this purpose, the accompanying drawings and the detailed description have been provided.

Accordingly, some of the constituent elements described in the accompanying drawings and the detailed description can include not only constituent elements essential for solving the problem, but also constituent elements not being essential for solving the problem but provided for illustrating the above technique. For this reason, these nonessential constituent elements should not be recognized as essential as soon as these nonessential constituent elements are described in the accompanying drawings and the detailed description.

In addition, since the embodiments described above are intended to exemplify the technique in the present disclosure, it is possible to make various modifications, replacements, additions, omissions, and the like within the scope of claims or the equivalent thereto.

INDUSTRIAL APPLICABILITY

The present disclosure is applicable to various applications using a plurality of light beams, and is applicable to various laser processing techniques, for example.

**Claims**

1.  An optical system for guiding a plurality of light beams from a light source array in which a plurality of light sources are arranged, the optical system comprising:

    a first collimator lens disposed facing the light source array, configured to collimate each light beam in at least a vertical direction among the vertical direction and an arrangement direction of the plurality of light sources, the vertical direction intersecting the arrangement direction and an optical axis direction of each light beam;
    an optical element disposed on an emission side of each light beam in the first collimator lens; and
    a second collimator lens disposed on an emission side of each light beam in the optical element, configured to collimate each light beam at least in the arrangement direction,
    wherein the first collimator lens includes a plurality of lens portions arranged in the arrangement direction, the plurality of lens portions corresponding to the plurality of light sources in the light source array, and
    the plurality of lens portions are configured rotationally asymmetrically to have positive power in the vertical direction and have positive power in the arrangement direction.

2.  The optical system according to claim 1, wherein

    the light beams of the light source array are emitted from the respective light sources with a divergence angle in the arrangement direction being smaller than a divergence angle in the vertical direction, and
    for each lens portion in the first collimator lens, the positive power in the arrangement direction is smaller than the positive power in the vertical direction.

3.  The optical system according to claim 1 or 2, wherein the second collimator lens has positive power in the arrangement direction and positive power in the vertical direction.

4.  The optical system according to claim 3, wherein the second collimator lens is configured rotationally symmetrically for the optical axis direction and is disposed at a focal length from an emission side surface of the optical element.

5.  The optical system according to any one of claims 1 to 4, wherein

    the first collimator lens is disposed to collimate each light beam from the light source array in the vertical direction and the arrangement direction, and
    the second collimator lens is disposed to collimate each light beam from the optical element in the arrangement direction and the vertical direction.

6.  The optical system according to any one of claims 1 to 5, wherein the optical element is configured to rotate each light beam incident from the first collimator lens around the optical axis direction.

7.  The optical system according to any one of claims 1 to 6, wherein the first collimator lens includes an emission side surface of each light beam, the emission side surface having a convex shape in the vertical direction and a convex shape in the arrangement direction for each of the lens portions, the convex shape in the arrangement direction being different from the convex shape in the vertical direction.

8.  The optical system according to claim 7, wherein the first collimator lens includes an incident side surface of each light beam, the incident side surface being a flat surface.

9.  The optical system according to claim 7, wherein the first collimator lens includes an incident side surface of each light beam, the incident side surface having a convex shape for each lens portion in the arrangement direction.

10. The optical system according to claim 7, wherein the first collimator lens includes an incident side surface of each light beam, the incident side surface having a convex shape in the vertical direction.

11. The optical system according to any one of claims 1 to 6, wherein the first collimator lens includes an incident side surface and an emission side surface of each light beam, the incident side surface having a convex shape for each lens portion in the arrangement direction, and the emission side surface having a convex shape in the vertical direction.

12. A laser device comprising:

   the light source array including the plurality of light sources arranged in the arrangement direction, configured to emit the plurality of light beams; and
   the optical system according to any one of claims 1 to 11 configured to guide the plurality of light beams from the light source array.

13. The laser device according to claim 12, further comprising:

   a diffractive element configured to diffract each light beam at an angle corresponding to a wavelength of each light beam guided from the light source array in the optical system; and
   an output coupler configured to reflect a part of the light beam diffracted by the diffractive element back to the light source, and output a rest of the light beam.

14. The laser device according to claim 13, further comprising a processing head configured to irradiate a processing object with a light beam output from the output coupler of the optical resonator.

15. A collimator lens for collimating a plurality of light beams from a light source array in which a plurality of light sources are arranged, the collimator lens comprising:

   a plurality of first lens portions arranged in an arrangement direction, the plurality of lens portions corresponding to the plurality of light sources in the light source array,
   wherein the plurality of first lens portions are provided rotationally asymmetrically to have positive power in a vertical direction and to have positive power in the arrangement direction, the vertical direction intersecting the arrangement direction and an optical axis direction of each light beam.

16. An optical system comprising:

   the collimator lens according to claim 15; and
   an optical element disposed on an emission side of each light beams in the collimator lens,
   wherein the optical element includes a plurality of second lens portions arranged to rotate the respective light beams incident from the collimator lens around the optical axis direction.

17. A laser device comprising:

   the light source array including the plurality of light sources arranged in the arrangement direction, configured to emit the plurality of light beams; and
   the collimator lens according to claim 15 configured to guide the plurality of light beams from the light source array.

## Fig. 1

Fig. 2

Fig. 3

Fig. 4

41

43

# Fig. 5

EP 4 387 015 A1

Fig. 6A

Fig. 6B

Fig. 7A

Fig. 7B

EP 4 387 015 A1

EP 4 387 015 A1

*Fig. 8A*

4

45

40

41(43)    42(44)

30

Bs

Af

As

Y

As

Af

X      Z

*Fig. 8B*

4

45

40

41(43)    42(44)

30

As   Bs

Af

Af

As

X

Y      Z

# Fig. 9

FROM LASER ELEMENT 31 — $\lambda 1$

FROM LASER ELEMENT 32 — $\lambda 2$

FROM LASER ELEMENT 33 — $\lambda 3$

$\alpha 1$, $\alpha 2$, $\alpha 3$, $\beta$

25

TO OUTPUT COUPLER 25

*Fig. 10*

## Fig. 11A
TYPICAL EXAMPLE

## Fig. 11B
FIRST EMBODIMENT

*Fig. 12*

| FIRST EMBODIMENT | |
|---|---|
| LENS THICKNESS | 0.223 |
| | |
| EMISSION SURFACE SIDE | |
| X CURVATURE RADIUS | -0.15 |
| Y CURVATURE RADIUS | -0.1145 |
| CONIC CONSTANT (KX) | -1.0365 |
| CONIC CONSTANT (KY) | -1.0365 |
| AR | -53.8332 |
| BR | -645.604 |
| CR | -66233 |
| DR | 1835580 |
| AP | 0 |
| BP | 0 |
| CP | 0 |
| DP | 0 |

D1

D11

Fig. 13A

Fig. 13B

Fig. 14

41a

43a

Y

X

Z

## Fig. 15A

SECOND EMBODIMENT

## Fig. 15B

SECOND EMBODIMENT (HALF FOCAL LENGTH)

# Fig. 16

| SECOND EMBODIMENT | |
|---|---|
| LENS THICKNESS | 0.223 |
| INCIDENT SURFACE SIDE | |
| X CURVATURE RADIUS | 0.02056878 |
| CONIC CONSTANT (k) | −3.01443926 |
| 4TH ORDER COEFFICIENT (A) | 30.3910391 |
| 6TH ORDER COEFFICIENT (B) | −4364.8459 |
| 8TH ORDER COEFFICIENT (C) | 260460.99 |
| 10TH ORDER COEFFICIENT (D) | −5613112.36 |
| EMISSION SURFACE SIDE | |
| Y CURVATURE RADIUS | −0.1145 |
| CONIC CONSTANT (k) | −1.0365 |
| 4TH ORDER COEFFICIENT (A) | −53.8332 |
| 6TH ORDER COEFFICIENT (B) | −645.604 |
| 8TH ORDER COEFFICIENT (C) | −66233 |
| 10TH ORDER COEFFICIENT (D) | 1835580 |

D1

D10a

D11a

# Fig. 17

<u>41b</u>

43b

Y

X

Z

# Fig. 18

(THIRD EMBODIMENT)

## *Fig. 19*

| THIRD EMBODIMENT | |
|---|---|
| LENS THICKNESS | 0.223 |
| | |
| INCIDENT SURFACE SIDE | |
| X CURVATURE RADIUS | 0.101 |
| CONIC CONSTANT (k) | −55.077742 |
| | |
| EMISSION SURFACE SIDE | |
| X CURVATURE RADIUS | −0.12 |
| Y CURVATURE RADIUS | −0.1145 |
| CONIC CONSTANT (KX) | −0.5794629 |
| CONIC CONSTANT (KY) | −1.0365 |
| AR | −36.771401 |
| BR | 4.2605974 |
| CR | −65628.982 |
| DR | 2462724.1 |
| AP | −0.2099572 |
| BP | 6.33128508 |
| CP | −0.002293 |
| DP | 0.05708725 |

D1

D10b

D11b

## Fig. 20

41c

43c

Y

X

Z

Fig. 21

(FOURTH EMBODIMENT)

## Fig. 22

| FOURTH EMBODIMENT | |
|---|---|
| LENS THICKNESS | 0.223 |
| INCIDENT SURFACE SIDE | |
| Y CURVATURE RADIUS | 0.101 |
| CONIC CONSTANT (k) | −55.0777417 |
| EMISSION SURFACE SIDE | |
| X CURVATURE RADIUS | −0.1145 |
| Y CURVATURE RADIUS | −0.12 |
| CONIC CONSTANT (KX) | −1.0365 |
| CONIC CONSTANT (KY) | −0.57946293 |
| AR | −36.7714006 |
| BR | 4.260597355 |
| CR | −65628.982 |
| DR | 2462724.135 |
| AP | 0.20995721 |
| BP | −6.33128508 |
| CP | 0.002292983 |
| DP | −0.05708725 |

D1

D10c

D11c

## INTERNATIONAL SEARCH REPORT

| International application No. |
| --- |
| **PCT/JP2022/012827** |

**A. CLASSIFICATION OF SUBJECT MATTER**

*H01S 5/02253*(2021.01)i; *H01S 5/02255*(2021.01)i; *H01S 5/14*(2006.01)i; *G02B 3/00*(2006.01)i
FI: G02B3/00 A; H01S5/02253; H01S5/02255; H01S5/14

According to International Patent Classification (IPC) or to both national classification and IPC

**B. FIELDS SEARCHED**

Minimum documentation searched (classification system followed by classification symbols)

H01S5/02253; H01S5/02255; H01S5/14; G02B3/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | WO 2019/163335 A1 (PANASONIC INTELLECTUAL PROPERTY MANAGEMENT COMPANY, LIMITED) 29 August 2019 (2019-08-29)<br>entire text, all drawings | 1-17 |
| A | JP 2013-518299 A (OCLARO PHOTONICS, INCORPORATED) 20 May 2013 (2013-05-20)<br>entire text, all drawings | 1-17 |
| A | JP 2011-520292 A (OCLARO PHOTONICS, INCORPORATED) 14 July 2011 (2011-07-14)<br>entire text, all drawings | 1-17 |
| A | JP 2009-145457 A (SONY CORPORATION) 02 July 2009 (2009-07-02)<br>entire text, all drawings | 1-17 |
| A | US 2007/0268571 A1 (NEWPORT CORPORATION) 22 November 2007 (2007-11-22)<br>entire text, all drawings | 1-17 |

☐ Further documents are listed in the continuation of Box C.  ☑ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **11 May 2022** | **31 May 2022** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT
**Information on patent family members**

International application No.

**PCT/JP2022/012827**

| Patent document cited in search report | | | Publication date (day/month/year) | Patent family member(s) | | | Publication date (day/month/year) |
|---|---|---|---|---|---|---|---|
| WO | 2019/163335 | A1 | 29 August 2019 | US | 2020/0379248 | A1 | |
| | | | | entire text, all drawings | | | |
| | | | | EP | 3761463 | A1 | |
| | | | | CN | 111819740 | A | |
| JP | 2013-518299 | A | 20 May 2013 | US | 2013/0058124 | A1 | |
| | | | | entire text, all drawings | | | |
| | | | | CN | 102934298 | A | |
| JP | 2011-520292 | A | 14 July 2011 | US | 2011/0103056 | A1 | |
| | | | | entire text, all drawings | | | |
| | | | | CN | 102089943 | A | |
| JP | 2009-145457 | A | 02 July 2009 | (Family: none) | | | |
| US | 2007/0268571 | A1 | 22 November 2007 | WO | 2007/137005 | A2 | |
| | | | | entire text, all drawings | | | |

Form PCT/ISA/210 (patent family annex) (January 2015)

**REFERENCES CITED IN THE DESCRIPTION**

**Patent documents cited in the description**

- US 20160048028 A